# EUROPEAN PATENT APPLICATION

(11) **EP 2 045 849 A2**
(43) Date of publication of application: **08.04.2009**
(21) Application number: 08155641.7
(22) Date of filing: 05.05.2008
(51) Int. Cl.: H01L 51/52, H01L 51/44

(54) **Conducting substrate structure with controlled nanorod density and method of fabricating the same**

(30) Priority: 01.10.2007 KR 20070098886
(71) Applicant: Electronics and Telecommunications Research Institute, Daejeon-city (KR)
(72) Inventor: Jun, Yongseok, Daejeon-city (KR); Kang, Mangu, Daejeon-city (KR); Lee, Seung Yup, Gyeongsan-city, Kyungsangbuk-do (KR); Yun, Ho Gyeong, Seoul (KR); Park, Jong Hyeok, Daejeon-city (KR); Park, Hun Kyun, Daejeon-city (KR); Kim, Jong Dae, Daejeon-city (KR)
(74) Representative: Betten & Resch

(57) **Abstract**

The present invention provides a conductive substrate structure with controlled nanorod density so that the contact between a conductive substrate and an active layer can be expanded, and a method of manufacturing the conductive substrate structure. The conductive substrate structure includes: a base substrate (100), and a conductive substrate (200) formed on the base substrate (100), and surface treated with an organic molecule; and nanorods (300) grown from a seed layer applied on the conductive substrate, wherein the seed layer is applied only on a predetermined region of the conductive substrate by using the self-assembling characteristics of the organic molecule, and thus, controlling the density of the nanorods (300). Furthermore, the method of manufacturing the substrate structure includes: treating a conductive substrate (200), formed on top of a base substrate (100), with an organic molecule; applying the seed layer only to a predetermined region of the conductive substrate by using the self-assembling characteristics of the organic molecules: and growing nanorods (300) with a controlled density from the seed layer.

## Description

### CROSS-REFERENCE TO RELATED PATENT APPLICATION

This application claims the benefit of Korean Patent Application No. 10-2007-0098886, filed on October 1, 2007, in the Korean Intellectual Property Office, the disclosure of which is incorporated herein in its entirety by reference.

### BACKGROUND OF THE INTENTION

### 1. Field of the Invention

The present invention relates to the solar cell or LED field, and more particularly, to a conductive substrate used as an electrode in the solar cell or LED field, and a method of manufacturing the conductive substrate. The present invention has been brought forth from research carried out as a part of the IT New Growth-driving Core Technology Development Project by the Ministry of Information and Telecommunications (Assignment Management No.: 2006-S-006-02, Assignment Name: Component/Module for Ubiquitous Terminal).

### 2. Description of the Related Art

Zinc oxide, which is a binary oxide semiconductor that has a wurzite crystalline structure with a hexagonal system, is a direct transition group 3-5 compound semiconductor material, with a wide bandgap of 3.37eV and a high exciton binding energy at room temperature. Zinc oxide is used as a replacement material for indium oxide in flat-panel displays or used as a short-wave material at low voltage such as light-emitting devices and laser diodes, since zinc oxide is a material with high permissivity and refractive index and a large piezoelectric constant in the visible light region.

Moreover, the material is used in field emitting displays, or transparent electrodes, gas sensors, and UV screens of solar cells. The zinc oxide used in electronic devices was generally used in the form of a thin film, but currently it is used in the form of a nanorod or a nanowire. This is because, by forming a nanostructure, the critical emission current density can be increased, and thus, obtaining maximum efficiency, and when the zinc oxide nanorods are coated on a glass substrate, the photocatalytic efficiency can be enhanced to a maximum by increasing the area of exposure to a maximum. When the nanoparticles are coated on a zinc oxide nanorod substrate with controlled density to produce a solar cell, electrons produced from the nanoparticles can flow directly to the substrate along the nanorods without passing through the many nanoparticles, thereby reducing the internal resistance of the cell. The reduction of electron loss caused by internal resistance leads to an increase in the efficiency of the cell.

Also, the conductive substrate is used very broadly as an electrode in fields such as the solar cells or LED (light-emitting diode) fields, and the conductive substrate acts as both a foundation for supporting an active layer and an electrode. Such a conductive substrate is subjected to various attempts to increase the surface area in contact with the active layer in order to enhance the efficiency of the cell. The evenness of the surface is controlled mostly at a micrometer level in order for the conductive substrate to increase its surface area, which also affects the transparency of the conductive substrate.

Increasing the surface area by treating the conductive substrate with the zinc oxide nanorods or nanoparticles is being attempted. However, the extension of the surface area with such a treatment is limited to only a few tens of nanometers, thereby setting a limit in terms of expanding the surface area.

### SUMMARY OF THE INVENTION

The present invention provides a conductive substrate structure with controlled nanorod density so as to increase the contact between a conductive substrate structure and an active layer, and a method of manufacturing the conductive substrate structure.

According to an aspect of the present invention, there is provided a conductive substrate structure with controlled nanorod density, the structure including: a base substrate, a conductive substrate formed on the base substrate and surface treated with an organic molecule; and nanorods grown from a seed layer applied on the conductive substrate, wherein the seed layer is applied only on a predetermined region of the conductive substrate by using the self-assembling characteristics of the organic molecule.

The base substrate of the present invention may be a glass or a metal substrate, and the conductive substrate may be a transparent FTO (F-doped SnO₂) or ITO (InSO₂) substrate. Meanwhile, the organic molecule may be one selected from the group consisting of silane series, phosphate series, sulfate series, and derivatives of a phosphate or a sulfate, wherein the phosphate series may include one functional group selected from the group consisting of phosphoric acid, phosphate, and hypophosphate; and the sulfate series may include one functional group selected from the group consisting of sulfuric acid, sulfate, and hyposulfate.

The seed layer of the present invention may be ZnO, which may be applied on the conductive substrate with a method selected from the group consisting of heat deposition, sputtering, and spin coating. After the nanorods are grown, the organic molecule may be removed by a heat treatment at 250 °C under oxygen atmosphere, or using a mixture solution of hydrogen peroxide and sulfuric acid.

The conductive substrate structure formed as such may have an expanded area of contact with the active layer by the nanorods with controlled density, and thereby be useful in organic solar cells or dye-sensitized nanocrystalline solar cells.

According to another aspect of the present invention there is provided a method of manufacturing a conductive substrate structure, the method including: treating a conductive substrate formed on a base substrate with an organic molecule; applying a seed layer on a predetermined region of the conductive substrate by using the self-assembling characteristics of the organic molecule; and growing the nanorods with controlled density from the seed layer.

The organic molecule of the present invention may be one selected from the group consisting of silane series, phosphate series, sulfate series, and derivatives of the phosphate or the sulfate, wherein the phosphate series may include one functional group selected from the group consisting of phosphoric acid, phosphate, and hypophosphate; and the sulfate series may include one functional group selected from the group consisting of sulfuric acid, sulfate, and hyposulfate.

In the case where the organic molecule is OTS (octadecyltrichlorosilane), the organic molecule treatment may be carried out by immersing the conductive substrate in OTS isooctane solution for 1 to 2 minutes, and in the case where the organic molecule is a phosphate, the organic molecule treatment may be carried out by immersing the conductive substrate in the phosphate solution dissolved in alcohol for 20 to 30 minutes. After the organic molecule treatment, the conductive substrate may be washed with isooctane.

The seed layer of the present invention may be ZnO, which may be applied using a method selected from the group consisting of heat deposition, sputtering, and spin coating. The ZnO seed layer is prepared by baking 1.10g of zinc acetate dehydrate at 180°C for 1 hour, and then leaving the resulting product in 50mL of ethanol at 60°C for 30 minutes, and zinc acetate monomer solution for growing the nanorods is prepared by drying the zinc acetate dehydrate in nitrogen atmosphere, and then reflexing the resulting product in 50ml of ethanol at 60°C for 2 hours, subsequently removing the remaining particles through centrifugation.

Meanwhile, the nanorods are grown to about 1 to 2µm by immersing the conductive substrate on which the ZnO seed layer is applied in the zinc acetate monomer solution for 24 hours or longer. After the nanorods are grown, the organic molecule is removed by a heat treatment under an oxygen atmosphere at 250 °C, or using a mixture solution of hydrogen peroxide and sulfuric acid.

The conductive substrate structure according to the present invention with controlled nanorod density and a method of manufacturing the conductive substrate structure are capable of appropriately controlling the nanorod density by treating the conductive substrate with an organic molecule and then growing the nanorods, thereby significantly increasing the contact surface area between a conductive substrate and an active layer.

Therefore, the conductive substrate structure according to the present invention can be used effectively in organic solar cells or dye-sensitized nanocrystalline solar cells in which an efficient increase in the contact area is desired.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a conductive substrate structure with controlled nanorods density, according to an embodiment of the present invention;
FIG. 2 is a cross-sectional view schematically illustrating a nanoparticle active layer being applied to the conductive substrate structure of FIG. 1; and
FIG. 3 is a flowchart illustrating a method of manufacturing a conductive substrate structure according to another embodiment of the present invention.

### DETAILED DESCRIPTION OF THE INVENTION

A conductive substrate is used in organic solar cells and light-emitting diodes (LEDs), and the contact between the conductive substrate and an active material thereon is very important. Various methods are currently used in order to increase such contact area, among which changing the surface evenness by etching or the like is most common.

Also, there have been attempts to increase the surface area using the fact that nanorods can be grown to a micrometer level. In the following description, the surface area of contact between the conductive substrate and an active layer includes a surface area of contact between nanorods formed on the conductive substrate and the active layer.

However, the method of growing the nanorods has a very limited practical applicability due to excessively high density of the grown nanorods. That is, except for the case where the nanorods themselves are the active layer, when the nanorods density is high, the air layer amongst the nanorods cannot be easily extracted, or it is difficult to fill the space between the nanorods with the active layer, therefore increasing contact with the active layer is very limited.

Moreover, if the nanorod density is too high, the contact area with polymers and the like may even be decreased. That is, at a high nanorod density, the polymers may not infiltrate the several-nanometer gap amongst the nanorods, and thus, forming only an air gap therein, and in turn reducing the contact area. Particularly, in the case of a solar cell, the active layer material is mostly a polymer structure or a colloid mixed with nanoparticles, not readily capable of infiltrating amongst the nanorods. Although it is important to remove air trapped amongst the nanorods by additionally performing a vacuuming process in order to facilitate efficient infiltration, it is preferable to fundamentally prevent such an incident by simply controlling the gaps between the nanorods.

Ultimately, it can be said that nanorods are not beneficial if the nanorod density is not appropriately controlled. If the gaps amongst the nanorods can be controlled, air gap formation can be prevented just by adjusting the gaps, and the contact formation between the nanorods and the active layer can be easily achieved. Therefore, controlling the nanorod density is very important with regards to conductive substrates using nanorods.

Hereinafter, the present invention will be described more fully with reference to the accompanying drawings, in which preferred embodiments of the invention are shown. Whenever it is written that an element exists "on" or "below" another element in the following description, the element may exist directly on top of or underneath another element, but an intervening element may also be present. In the drawings, the size and form of each element are exaggerated for clarity and convenience, and the parts that are irrelevant to the description will be omitted. Like reference numerals in the drawings denote like elements. Meanwhile, the terms used are merely used in order to describe the present invention, and not for the purpose of limiting the meaning or the scope of the invention as defined by the appended claims.

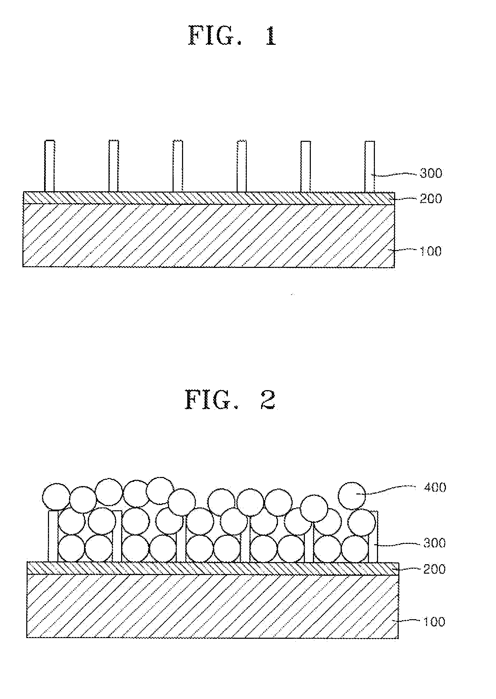

FIG. 1 is a cross-sectional view of a conductive substrate structure with controlled nanorods density, according to an embodiment of the present invention.

Referring to FIG. 1, the conductive substrate structure according to the present embodiment includes a base substrate 100, a conductive substrate 200 on the base substrate 100, and nanorods 300 formed on the conductive substrate 200.

The base substrate 100 may be a glass or metal-based substrate, and the conductive substrate 200 may be an FTO (F-doped SnO₂) or ITO (InSnO₂)-based substrate. Also, such a conductive substrate 200 undergoes organic molecule treatment before the nanorod 300 growth, and this is performed in order for the nanorods 300 to grow with an appropriate density on the conductive substrate 200.

More specifically, the nanorods 300 are grown by a seed layer applied on the conductive substrate 200 to a length of 1 to 2µm, and by treating the conductive substrate 200 with an organic molecule, the seed layer is applied to only a predetermined region of the conductive substrate according to the self-assembling properties of the organic molecule. Accordingly, the nanorods 300 grown from the seed layer are grown at an appropriately controlled spots depending on the position of the seeds. That is, by treating the conductive substrate 200 with the organic molecule, the conductive substrate 200 whereon nanorods 300 are formed at an appropriate density can be implemented.

The organic molecule may include silane series, phosphate series, sulfate series, or a derivative of the phosphate or the sulfate. The organic molecule including a phosphate series may be a phosphoric acid, or its corresponding functional groups such as phosphate or hypophosphate, and the organic molecule including a sulfate series may be a sulfuric acid or its corresponding functional group such as sulfate or hyposulfate.

By adjusting the concentration and the treatment time of the organic molecules when treating the conductive substrate 200, the self-assembling degree of the organic molecule on the conductive substrate can be controlled. On the conductive substrate treated with the organic molecule as such, an appropriate seed layer, such as ZnO seed layer may be applied only on areas where the organic molecule is not present. Here, the application of the seed layer may be carried out using heat deposition, sputtering, or spin coating.

The nanorods 300 are grown from the seed layer applied on a predetermined area, such that the density of the nanorods 300 is automatically controlled, and thereby enabling the implementation of a conductive substrate with the density of the nanorods 300 controller, Also, following the growth of the nanorods 300, an active layer such as an active layer of nanoparticles are applied over the conductive substrate 200, in which the organic molecule present on the conductive substrate 200 is removed by heat treating at 250°C under an oxygen atmosphere before or after applying the nanoparticles. Moreover, besides the heat treatment, the organic molecule may also be removed by immersing the conductive substrate 200 in a mixture solution of hydrogen peroxide and sulfuric acid. When the organic molecule is removed, only the nanorods 300 with a controlled density exist on the conductive substrate 200.

The conductive substrate structure with controlled nanorod density according to the present invention is capable of appropriately controlling the nanorod density by treating the conductive substrate with an organic molecule and then growing the nanorods, thereby significantly increasing the contact surface area between the conductive substrate and the active layer. Therefore, the conductive substrate structure according to the present invention can be used effectively in organic solar cells or dye-sensitized nanocrystalline solar cells in which an efficient increase in the contact area is desired.

FIG. 2 is a cross-sectional view of schematically illustrating an active layer being applied to the conductive substrate structure of FIG. 1.

Referring to FIG. 2, the active layer such as an active layer of nanoparticles 400 is applied on the conductive substrate structure of FIG. 1 with controlled density of the nanorods 300. Such nanoparticles 400 are used in a dye-sensitized nanocrystalline solar cell and the like as the active layer on the conductive substrate 200.

The dye-sensitized nanocrystalline solar cell, in contrast to a silicon-based solar cell employing a conventional p-n connection, is a photoelectrochemical solar cell of which main materials include a photosensitized dye molecule capable of producing an electron-hole pair by absorbing visible light, and a transition metal oxide transferring produced electrons. A representative example of a dye-sensitized nanocrystalline solar cell known to date is disclosed by Gratzel et. al. of Switzerland (U.S. Patent Laid-open Publication Nos. 4,927,721 and 5,350,644). The dye-sensitized nanocrystalline solar cell suggested by Gratzel et. al. is composed of a semiconductor electrode made of TiO₂ nanoparticles with dye molecules adsorbed thereto, and a counter electrode coated with platinum or carbon, and an electrolyte solution filled between the electrodes.

As shown in FIG. 2, the nanorods 300 on the conductive substrate 200 of the present embodiment are formed at a relatively low density, that is, with relatively wide gaps between the nanorods 300, in which the nanoparticles 400 are filled amongst the nanorods 300, and thus, the area of contact between the nanoparticles 400 and the conductive substrate 200 can be increased.

The present embodiment introduces nanoparticles as an active layer, but the active layer is not limited thereto. For example, because the conductive substrate 200 of the present embodiment has a low nanorod density, even if a polymer is used as the active layer, the polymeric active layer can conveniently permeate amongst the nanorods 300, and thus, maintaining an increased contact area with the conductive substrate 200.

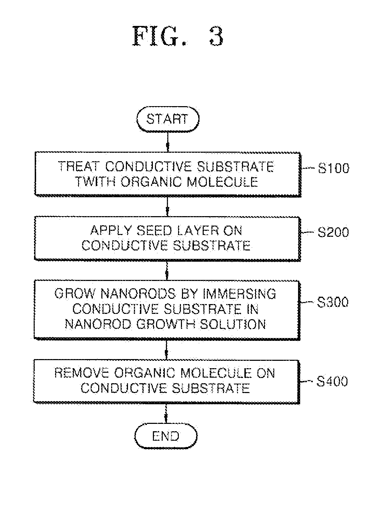

FIG. 3 is a flowchart illustrating a method of manufacturing the conductive substrate structure of FIG. 1, according to an embodiment of the present invention.

Referring to FIG. 3, in order to produce the conductive substrate structure of the present embodiment, the conductive substrate 200 formed on the base substrate 100 is first treated with an organic molecule (S100), where the organic molecule may be silane series, phosphate series, sulfate series, or a derivative of the phosphate or the sulfate, as previously described. Specifically, a silane such as OTS (octadecyltrichlorosilane) is used in the present embodiment. That is, a 20mM OTS isooctane solution is prepared, in which the conductive substrate 200 is immersed for 1 to 2 minutes for surface treatment. However, if a phosphate is used, the phosphate is dissolved in alcohol to prepare an alcohol-phosphate mixture solution, in which the conductive substrate 200 is immersed for 20 to 30 minutes for surface treatment. The surface of the conductive substrate 200 treated with the organic molecule as such may further be washed with an isooctane solution in order to remove any impurities or incompletely applied organic molecules.

When the conductive substrate 200 is treated with the organic molecule as such, the organic molecule is only applied to a predetermined area of the conductive substrate 200 due to the self-assembling properties of the organic molecule. Thus, it is clear that the concentration of the organic molecule or the treatment time can be appropriately adjusted without being limited to the conditions described above, so as to apply the organic molecule to the conductive substrate 200 with a suitable density.

Following the treatment of the conductive substrate 200 with the organic molecule, a seed layer such as a ZnO seed layer is applied on the conductive substrate 200 (S200). The ZnO seed layer can be applied using various methods such as heat deposition, sputtering, or spin coating. The ZnO seed may be formed by baking 1.10g of zinc acetate dehydrate at 180°C for 1 hour, and leaving the resulting product in 50 ml of ethanol at 60°C for 30 minutes.

When the ZnO seed prepared as such is sprayed evenly on the surface of the conductive substrate 200, treated with the organic molecule, by spin coating at 1500rpm, the ZnO seed layer is applied only on the parts where the organic molecule is absent. That is, as previously described, the organic molecule is applied only to a predetermined area according to its self-assembling characteristics, and the ZnO seed layer, having a low binding capacity with such organic molecule, is only applied to the conductive substrate 200 on the area not covered by the organic molecule. Accordingly, the ZnO seed layer is applied on the conductive substrate 200 in an automatic degree of controlled density.

The conductive substrate 200, on which the ZnO seed layer is applied, is hardened at about 200°C, and the conductive substrate 200 is immersed in a nanorod growth solution to grow the nanorods 300 (S300). The solution used to grow the nanorods 300 may be zinc acetate monomer solution, since the seed layer uses ZnO. Such zinc acetate monomer solution may be prepared by drying zinc acetate under nitrogen atmosphere, and then refluxing the zinc acetate in 50ml of ethanol at 60°C for 2 hours, and removing the remaining particles through centrifugation. The zinc acetate monomer solution prepared as such may be stored at a temperature lower than or equal to 5°C

The nanorods 300 can be grown to about 1 to 2µm by immersing the conductive substrate 200 on which the ZnO seed layer is applied in the zinc acetate monomer solution for 24 hours or longer, so that the nanorods 300 of desired length can be obtained by selecting an appropriate growth time.

Following the growth of the nanorods 300, the organic molecule existing on the conductive substrate 200 is removed (S400). The organic molecule can be removed, before or after applying an active layer, such as the nanoparticles 400 or polymers, on the conductive substrate 200 after the growth of the nanorods 300, by a heat-treatment under an oxygen atmosphere at 250°C. In addition, it is clear that, besides the heat treatment, the organic molecule can be removed by immersing the conductive substrate 200 in a mixture solution of hydrogen peroxide and sulfuric acid.

The method of manufacturing the conductive substrate structure according to the present invention is capable of appropriately controlling the nanorod density by treating the conductive substrate with an organic molecule and then growing the nanorods, thereby significantly increasing the contact surface area between a conductive substrate and an active layer.

Therefore, the conductive substrate structure manufactured according to the present invention can be used effectively in organic solar cells or dye-sensitized nanocrystalline solar cells in which an efficient increase in the contact area is desired.

While the present invention has been particularly shown and described with reference to exemplary embodiments thereof, it will be understood by one of ordinary skill in the art that various changes in form and details may be made therein without departing from the spirit and scope of the present invention as defined by the following claims.

In summary an embodiment of the invention can be described as follows: The present invention provides a conductive substrate structure with controlled nanorod density so that the contact between a conductive substrate and an active layer can be expanded, and a method of manufacturing the conductive substrate structure. The conductive substrate structure includes: a base substrate, and a conductive substrate formed on the base substrate, and surface treated with an organic molecule; and nanorods grown from a seed layer applied on the conductive substrate, wherein the seed layer is applied only on a predetermined region of the conductive substrate by using the self-assembling characteristics of the organic molecule, and thus, controlling the density of the nanorods. Furthermore, the method of manufacturing the substrate structure includes: treating a conductive substrate, formed on top of a base substrate, with an organic molecule; applying the seed layer only to a predetermined region of the conductive substrate by using the self-assembling characteristics of the organic molecules; and growing nanorods with a controlled density from the seed layer.

## Claims

1. A conductive substrate structure with controlled nanorod density, the structure comprising:
a base substrate;
a conductive substrate formed on the base substrate, and surface treated with an organic molecule; and
nanorods grown from a seed layer applied on the conductive substrate,
wherein the seed layer is applied only on a predetermined region of the conductive substrate by using the self-assembling characteristics of the organic molecule.

2. The conductive substrate structure of claim 1, wherein the base substrate is a glass or a metal substrate.

3. The conductive substrate structure of any of the preceding claims, wherein the conductive substrate is a transparent FTO (F-doped SnO₂) or ITO (InO₂) substrate.

4. The conductive substrate structure of any of the preceding claims, wherein the organic molecule is one selected from the group consisting of silane series, phosphate series, sulfate series, and derivatives of the phosphate or the sulfate,
wherein the phosphate series comprises one functional group selected from the group consisting of phosphoric acid, phosphate, and hypophosphate; and the sulfate series comprises one functional group selected from the group consisting of sulfuric acid, sulfate, and hyposulfate.

5. The conductive substrate structure of any of the preceding claims, wherein the seed layer is ZnO, such that the ZnO seed layer is applied on the conductive substrate by using a method selected from the group consisting of heat deposition, sputtering, and spin coating.

6. The conductive substrate structure of any of the preceding claims, wherein the organic molecule is removed by a heat treatment at 250°C or by a sulfate mixture solution, after the nanorods are grown.

7. The conductive substrate structure of any of the preceding claims, wherein the area of contact with the active layer is increased due to the nanorods with controlled density.

8. The conductive substrate structure of claim 7, wherein the conductive substrate structure is used in an organic solar cell or a dye-sensitized nanocrystalline solar cell.

9. A method of manufacturing a conductive substrate structure, the method comprising:
treating a conductive substrate, formed on a base substrate, with an organic molecule;
applying a seed layer on a predetermined region of the conductive substrate by using the self-assembling characteristics of the organic molecule; and
growing nanorods with controlled density from the seed layer.

10. The method of claim 9, wherein the conductive substrate is a transparent FTO (F-doped SnO₂) or ITO (InO₂) substrate; and the base substrate is a glass or a metal substrate.

11. The method of claim 9 or 10, wherein the organic molecule is one selected from the group consisting of silane series, phosphate series, sulfate series, and derivatives of the phosphate or the sulfate.

12. The method of claim 11, wherein the phosphate series comprises one functional group selected from the group consisting of phosphoric acid, phosphate, and hypophosphate; and the sulfate series comprises one functional group selected from the group consisting of sulfuric acid, sulfate, and hyposulfate.

13. The method of claim 11 or 12, wherein in the case where the organic molecule is OTS(octadecyltrichlorosilane), the organic molecule treatment may be carried out by immersing the conductive substrate in OTS isooctane solution for 1 to 2 minutes; and in the case where the organic molecule is a phosphate, the organic molecule treatment may be carried out by immersing the conductive substrate in the phosphate solution dissolved in alcohol for 20 to 30 minutes.

14. The method of claim 13, further comprising washing the conductive substrate with isooctane after the organic molecule treatment.

15. The method of any of claims 9 to 14, wherein the seed layer is ZnO, such that the ZnO see layer is applied on the conductive substrate treated with the organic molecule by using a method selected from the group consisting of heat deposition, sputtering, and spin coating.

16. The method of claim 15, wherein the ZnO seed layer is prepared by baking 1.10g of zinc acetate dehydrate at 180°C for 1 hour, and leaving the zinc acetate dehydrate in 50 ml of ethanol at 60°C for 30 minutes, and the zinc acetate monomer solution for growing the nanorods is prepared by drying the zinc acetate dehydrate under an nitrogen atmosphere, and then refluxing the zinc acetate dehydrate in 50ml of ethanol at 60°C for 2 hours, and removing the remaining particles through centrifugation.

17. The method of claim 16, wherein the nanorods are grown to about 1 to 2µm by immersing the conductive substrate on which the ZnO seed layer is applied in the zinc acetate monomer solution for 24 hours or longer.

18. The method of any of claim 9 to 17, wherein the organic molecule is removed, after the nanorods are grown, by a heat treatment under an oxygen atmosphere at 250°C or using a mixture solution of hydrogen peroxide and sulfuric acid.

19. The method of any of claims 9 to 17, wherein by controlling the density of the nanorods using the organic molecule treatment, the contact area of the active layer stacked on top of the conductive substrate is increased.
